# EUROPEAN PATENT APPLICATION

(11) **EP 4 531 108 A1**
(43) Date of publication of application: **02.04.2025**
(21) Application number: 23200009.1
(22) Date of filing: 27.09.2023
(51) Int. Cl.: H01L 29/06, H01L 29/78

(54) **IMPROVED RECESSED REGIONS OF A JUNCTION TERMINATION EXTENSION FOR SEMICONDUCTOR DEVICES**

(71) Applicant: Nexperia B.V., 6534 AB Nijmegen (NL)
(72) Inventor: Böttcher, Tim, 22529 Hamburg (DE); El-Zammar, Georgio, Hamburg (DE); Mazzillo, Massimo Cataldo, Hamburg (DE)
(74) Representative: Pjanovic, Ilija

(57) **Abstract**

The present disclosure presents a semiconductor device including a semiconductor body, wherein the semiconductor body includes one or more recessed regions in a P doped Junction Termination Extension, JTE, region, wherein a depth of the recessed regions is smaller than a depth of the JTE region, and an N+ implant at a bottom of the recessed regions. A method of manufacturing such semiconductor device is also presented.

## Description

### Technical field

The present disclosure relates to a method of manufacturing semiconductor device and a semiconductor device. More specifically the present disclosure is related to an improved recessed regions of a Junction Termination Extension (JTE) for semiconductor devices.

### Background

Most of planar and trench power devices are based of one or several n-type/p-type junctions. When the active part of the junction ends on the lateral side of the device, a very high electric field may appear under reverse voltage biasing due to junction curvature or trench corners.

A periphery protection, called edge termination may therefore be necessary. Edge termination is an important part of power devices. Passivation charges in the termination can result in reliability failures, low reverse blocking capability and poor Unclamped Inductive Switching (UIS) ruggedness.

Reliable and robust high voltage devices need effective edge termination structures to protect the device periphery, so that blocking values close to the ideal 1D avalanche voltage value can be achieved. Several physical limitations make, e.g., Silicon Carbide (SiC) edge terminations quite complex to design. The main limitation is the low diffusion coefficients of dopant atoms inside the semiconductor. Deep junctions (> 1µm) are difficult to implement, and lateral dopants diffusion is very limited. Moreover, the higher interface traps level observed in the SiC/passivation interface compared to Silicon is also affecting the efficiency of the standard Si terminations architectures in the SiC power devices. Charges may accumulate at the interface, generating breakdown voltage instabilities and early failures, especially with temperature.

In a bipolar transistor, there are parasitic components like the collector-base and emitter-base junction capacitances that can affect the transistor's high-frequency performance. The JTE technique involves intentionally adding a lightly doped region (typically a P-type region) near the collector or emitter junction to create a gradual transition between the highly doped region and the lightly doped region. This helps to reduce the capacitance at the junction, which in turn reduces the impact on the transistor's high-frequency response. Moreover, the JTE distributes the electric field laterally from active area to die edge in such a way, that the peak field may be minimized and no lateral or termination breakdown occurs. At the same time the termination should be robust against the movement or accumulation of charges under stress test or operation conditions.

One common termination design for SiC is the JTE. It may be used to reduce the impact of unwanted parasitic elements in the device structure and improve its performance. The breakdown voltage of the JTE region in a rectifier is highly sensitive to the doping concentration of the JTE (here but not limited to low p-type). This implies as well that the JTE termination is sensitive to charge accumulation in the region.

### Summary

A summary of aspects of certain examples disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

The present disclosure aims to overcome the drawbacks identified in the background section. More specifically, the present disclosure aims to reduce the electrical field in the critical interface region between JTE and passivation stack.

Hereto, the present disclosure presents an "inverted" Kao ring structure in the JTE region, which may be created through a dry etch step followed by an N+ implant. The dry etch step places the inverted Kao ring structure deeper into the JTE, such that the electric field at the surface is further reduced. Moreover, it allows the usage of a standard implant tool since the high implant energy for deep junctions is not needed. The distributed N+ Kao ring structure balances the charge in the termination and distributes the electric field, making it more robust against doping and charge variation. The Kao ring structure creation through a dry etch process allows very fine patterning without corner effects due to implant scattering.

According to an aspect of the present disclosure, a method of manufacturing a semiconductor device is presented. The method may include forming one or more recessed regions in a P doped Junction Termination Extension, JTE, implant of a semiconductor body. A depth of the recessed regions may be smaller than a depth of the JTE implant. The method may further include forming an N+ implant at a bottom of the recessed regions.

In an embodiment, the depth of the recessed regions may be smaller than half of the depth of the JTE implant.

In an embodiment, the method may include forming an N+ implant at the bottom and sidewalls of the recessed regions.

In an embodiment, the method may include forming the N+ implant by depositing a screen oxide layer in the recessed regions and poly spacers defined along the sidewalls by a prior photolithography and etching step.

In an embodiment, the method may include forming multiple N+ implants with increasing doping at the bottom of the recessed regions.

In an embodiment, the method may include forming the multiple N+ implants using multiple implantation steps with increasing dose and energy, producing a graded doping profile with increasing doping from a bottom of a trench to a bottom of the N+ implant.

In an embodiment, the multiple N+ implants may be two N+ implants.

In an embodiment, the method may include forming multiple recessed regions having a substantially constant width and a substantially constant spacing.

In an embodiment, the method may include forming multiple recessed regions having a spacing that increases along the JTE implant from an active area up to an outer edge of a termination.

In an embodiment, the method may include etching a further recessed region outside of the JTE implant and near a die edge in a saw lane. The further recessed region may be etched during the same process used for forming the recessed regions in the JTE.

In an embodiment, the method may include forming an N+ implant at a bottom of the further recessed region during the same process used for forming the N+ implant at the bottom of the recessed regions.

In an embodiment, the method may include forming a P doped surface layer on top of a top surface of the JTE implant and in an area between the recessed regions.

According to an aspect of the present disclosure, a semiconductor device is presented. The semiconductor device may include a semiconductor body. The semiconductor body may include one or more recessed regions in a P doped Junction Termination Extension, JTE, region. A depth of the recessed regions may be smaller than a depth of the JTE region. The semiconductor body may further include an N+ implant at a bottom of the recessed regions.

In an embodiment, the N+ implant may cover sidewalls of the recessed regions.

In an embodiment, the semiconductor device may include multiple N+ implants with increasing doping at the bottom of the recessed regions.

In an embodiment, the semiconductor body may include a P doped surface layer in an area between the recessed regions.

In an embodiment, the semiconductor device may be created using a method having one or more of the above described features..

### Brief description of the Drawings

Embodiments of the present disclosure will now be described, by way of example only, with reference to the accompanying schematic drawings in which corresponding reference symbol indicate corresponding parts, in which:
Figs. 1-5 show cross-sectional side views of example embodiments of a semiconductor body;
Fig. 6 schematically shows a semiconductor device including a semiconductor body according to an example embodiment; and
Fig. 7 shows a flow chart of a method of an example embodiment.
The figures are intended for illustrative purposes only, and do not serve as restriction of the scope of the protection as laid down by the claims.

### Detailed description

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure but is merely representative of various embodiments. While the various aspects of the embodiments are presented in drawings, the drawings are not necessarily drawn to scale unless specifically indicated.

The described embodiments are to be considered in all respects only as illustrative and not restrictive. The scope of the present disclosure is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present disclosure should be or are in any single example of the present disclosure. Rather, language referring to the features and advantages is understood to mean that a specific feature, advantage, or characteristic described in connection with an embodiment is included in at least one embodiment of the present disclosure. Thus, discussions of the features and advantages, and similar language, throughout this specification may, but do not necessarily, refer to the same example.

Furthermore, the described features, advantages, and characteristics of the present disclosure may be combined in any suitable manner in one or more embodiments. One skilled in the relevant art will recognize, in light of the description herein, that the present disclosure may be practiced without one or more of the specific features or advantages of a particular embodiment. In other instances, additional features and advantages may be recognized in certain embodiments that may not be present in all embodiments of the present disclosure. Reference throughout this specification to "one embodiment," "an embodiment," or similar language means that a particular feature, structure, or characteristic described in connection with the indicated embodiment is included in at least one embodiment of the present disclosure. Thus, the phrases "in one embodiment," "in an embodiment," and similar language throughout this specification may, but do not necessarily, all refer to the same embodiment.

An improvement in termination behavior may be obtained by etching recessed regions with possibly different geometry (i.e., width and/or spacing) inside the JTE and implanting the bottom of the etched regions with N+ implant. The recessed regions have a depth lower than the depth of the JTE implant and in some embodiments they may have different width and/or spacing along the JTE. As a result, the electrical field at the JTE surface may be spread and reduced, and the lateral doping across the same termination may be modulated. I.e., modulation of the lateral P doping profile and increase of the electrical field uniformity in the JTE by using recessed regions whose characteristics may be defined by layout (e.g., width and/or spacing) and/or process (e.g., depth, aspect ratio, and/or taper angle).

A continuous or segmented P-doped surface layer may be created in the area between contiguous recessed regions with the purpose to reduce the risk of surface inversion, making the termination more robust against processes (e.g., PECVD deposition, Reactive Ion Etching (RIE), etc.) inducing high surface charge density on the JTE surface.

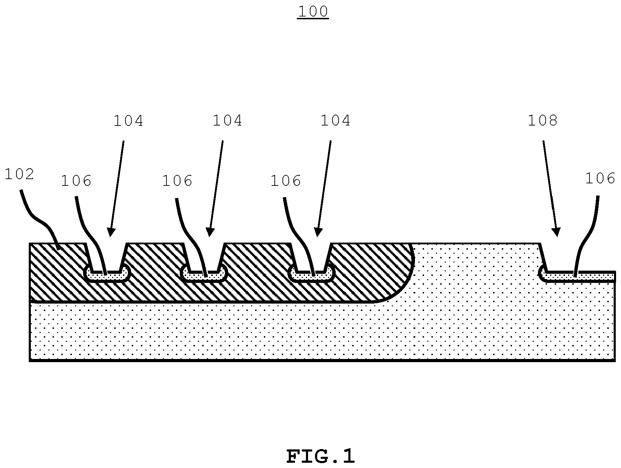

Fig. 1 shows an example embodiment of a semiconductor body 100, including a P type doped JTE 102 with recessed regions 104 having an N+ implant 106 at the bottom of the recessed regions 104. The recessed regions 104 may be etched inside the P-doped JTE 102.

In an example, the P doped layer 102 may have a doping between 3E16cm-3 and 8E17cm-3, preferably 1E17cm-3, and a depth between 0.5um and 1.5um, preferably 1um.

The recessed regions 104 may have a depth lower than half of the JTE 102 depth, and preferably a depth lower than 0.5um.

In a preferred embodiment, the recessed regions 104 have a constant width and spacing, e.g., a width in the range of 0.5um-1.5um and a spacing in the range of 3um-5um, preferably a width of 1 um and a spacing of 4 um.

In another embodiment, the spacing between recessed regions 104 is not constant and increases along the JTE 102 from the active area up to outer edge of the termination, for example of 50%.

A larger recessed region 108 may be etched at the die edge and in the saw lane. This region 108 may be etched during the same process used for forming the recessed regions 104 in the JTE 102 and therefore may have the same depth of these regions.

In the example embodiment of Fig. 1, the N+ doped implanted regions 106 are at the bottom of the recessed regions 104, including the region 108 defined at the die edge and acting as a channel stopper. In an example, the N+ regions 106 may have a doping between 1E18cm-3 and 1E19 cm-3, preferably 5E18 cm-3, and a depth between 0.1 um and 0.3um, preferably 0.2um.

The sum of the depths of a recessed region 104 including an N+ implanted regions 106 in the JTE 102 is preferably lower than the JTE 102 depth itself.

In an example embodiment, the N+ implant 106 may be performed through a screen oxide layer deposited in the recessed regions and poly spacers defined along the sidewalls by a prior photolithography and etching step. The poly spacers may be used to prevent that the sidewalls of the recessed regions are implanted with N-type dopant.

The semiconductor body 100 of Fig. 1 may include suitable passivation layers in the form of one single layer or a passivation stack including oxide based and nitride based dielectric layers (not shown in the figure). The passivation layers may cover the whole termination area.

The use of recessed regions 104 inside the JTE 102 and shallow N+ implants 106 at the bottom of the recess regions 104 enable reduction of the electrical field at JTE surface where interface states are present, due to passivation layer deposition and/or other process steps (e.g. oxidation or etching). A high electrical field at the surface region with high density of interface states may trigger trapping or emission of carriers, resulting at the end in leakage increase and unstable termination behavior, due to an unbalanced working of the JTE, especially under high bias and temperature conditions.

Advantageously, the placement of the N+ implant regions 106 in recessed regions 104 can be effective in keeping the electric field away from the surface, since the inverted Kao ring structure is placed deeper into the SiC. This is not possible with standard, known implants.

Moreover, the use of etched regions with possibly different width and/or spacing allows to laterally modulate the JTE doping where the control of the doping along the termination region is defined by the geometry of the recessed regions. Advantageously, this allows for an improved and more flexible control of the lateral doping, compared to the use of standard, known implantation techniques.

The N+ implant 106 inside the recessed regions 104 can advantageously be carried out during the same implantation step used to create the channel stopper region at the die edge, usually included at least in high voltage power devices. Therefore, the semiconductor body 100 with improved working of the JTE can be obtained by using a device/process architecture with reduced technology complexity and production costs.

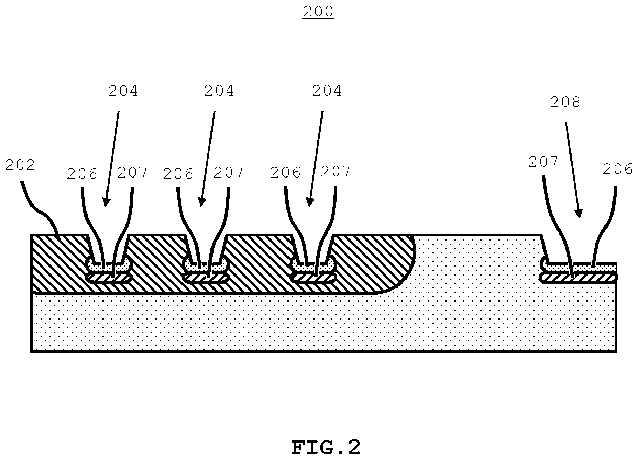

Fig. 2 shows an example embodiment of a semiconductor body 200, including a P type doped JTE 202 with recessed regions 204 having multiple N+ implants 206, 207 with increasing doping at the bottom of the recessed regions 204. The recessed regions 204 may be etched inside the P-doped JTE 202.

Similar to the N+ implant 106 being present at the bottom of the recessed regions 104 and 108 in the example of Fig. 1, in the example of Fig. 2 the multiple N+ implants 206, 207 may be present at the bottom of the recessed regions 204 and at the bottom of the channel stopper area 208.

The multiple N+ implants 206, 207 may be formed by using multiple implantation steps with increasing dose and energy, producing a graded doping profile with increasing doping from the bottom of the trench to the bottom of the N+ implant.

In the example of Fig. 2, two N type implanted regions are created at the bottom of the trench 204, the first 206 with lower doping around the bottom of the trench 204 and second 207 deeper in the JTE 202 with higher doping. The second N type implanted region 207 is typically contiguous to the first N type implanted region 207.

Both N type implanted regions 206, 207 may have the same depth, e.g., 0.15 um. Both N type implanted regions 206, 207 may have different doping, e.g., the first surface region 206 around 1E18 cm-3 and the second deeper region 207 around 1E19 cm-3.

Compared to Fig. 1, the graded doping profile as a result of having multiple N+ implants 206, 207 at the bottom of the recessed regions 204 may help to further reduce the electrical field at the JTE surface and may be beneficial to reduce the implantation damage at the bottom of the recessed region, which is typically highly defective due to the etching process used to form the recessed areas.

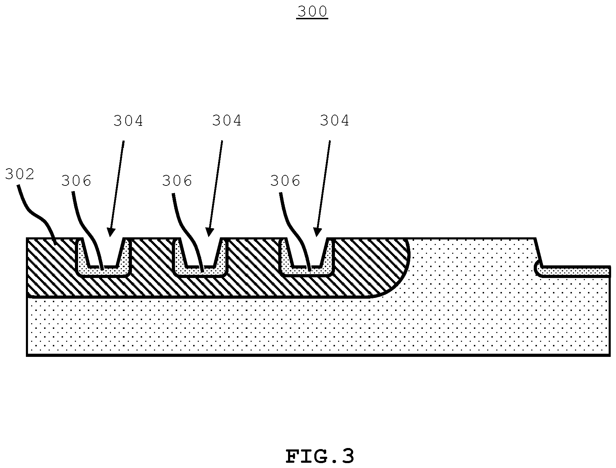

Fig. 3 shows an example embodiment of a semiconductor body 300, including a P type doped JTE 302 with recessed regions 304 having an N+ implant 306 at the bottom and along the sidewalls of the recessed regions 304. The recessed regions 304 may be etched inside the P-doped JTE 302. The semiconductor body 300 is similar to the semiconductor body 100 of Fig. 1, with the addition of the N+ dopant 306 being implanted also along the sidewalls of the recessed regions 304.

The implantation of the recessed regions sidewalls with N-type dopant, such as shown in Fig. 3, can be beneficial to further reduce the electrical field at the JTE surface since the N+ implanted volume is increased and extends as well in the vertical direction.

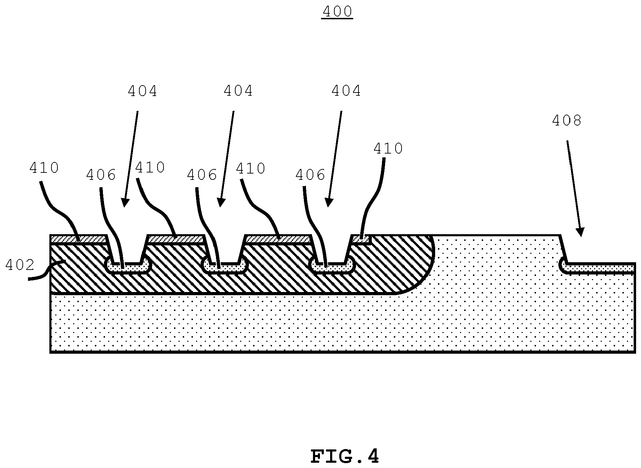

Fig. 4 shows an example embodiment of a semiconductor body 400, including a P type doped JTE 402 with recessed regions 404 having an N+ implant 406 at the bottom of the recessed regions 404. The recessed regions 404 may be etched inside the P-doped JTE 402. The semiconductor body 400 is similar to the semiconductor body 100 of Fig. 1, with the addition of a P+ enrichment layer 410 being defined on the JTE 402 surface in the area included between contiguous recessed regions 404. In this example, the P+ enriched layer 410 does not extend until the end of the termination.

The P+ layer 410 may be defined by implantation. In an example, the P+ layer 408 may have a doping between 1E18cm-3 and 1E19cm-3, preferably 5E18cm-3, and a depth between 0.1µm and 0.3µm, preferably 0.2µm.

In an example embodiment, the P+ layer 410 may be implanted before the etching of the recessed regions 404 and subsequent N+ implantation 406.

The use of an addition of a P+ enrichment layer 410 can advantageously reduce the risk of surface inversion and increase the electrical field uniformity along the termination, thus reducing the probability of early breakdown, either at zero hour or after stress test.

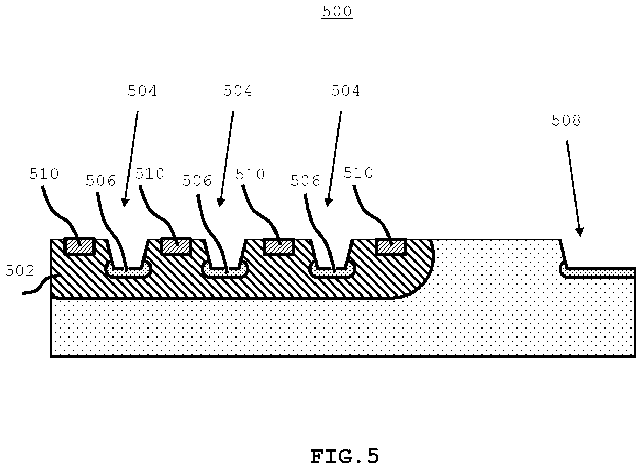

Fig. 5 shows an example embodiment of a semiconductor body 500, including a P type doped JTE 502 with recessed regions 504 having an N+ implant 506 at the bottom of the recessed regions 504. The recessed regions 504 may be etched inside the P-doped JTE 502. The semiconductor body 500 is similar to the semiconductor body 400 of Fig. 4, but with the P+ layer 510 being defined just in between the contiguous recessed areas 504 and laterally spaced from them.

The peripheral region between the more external recessed area 508 and the end of the JTE 502 might eventually not include the P+ enrichment layer 510. In the example of Fig. 5, the P+ layer 510 may be equivalently implanted before the etching of the recessed regions 504 or after the etching of the recessed regions 504 and subsequent implantation with N+ dopant 506.

A P+ surface layer, such as the P+ surface layer 410 or the P+ surface layer 510, may be integrated similarly in the semiconductor body 200 or semiconductor 300.

The present disclosure may be used in SiC semiconductors, where SiC plasma etching may involve both chemical and physical mechanisms. The etching of the recessed regions 104, 204, 304, 404, 505 in SiC requires the breaking of Si-C bonds, followed by the chemical interaction of reactive species with silicon and carbon to produce volatile compounds. Plasma chemistries based on highly reactive fluorine radicals may generate volatile SiFx and CFx products. Accordingly, CF4, SF6, NF3, CBrF3, and CHF3 are the typical reactant gases, even though some gas mixtures are sometimes also used. The etching of SiC with fluorinated gases is usually carried out with the aid of additional noble gases for mass transport.

One of the characteristics of the etched recession regions 104, 204, 304, 404, 504 is the taper angle, defined as the supplementary angle to the angle between the sidewalls and the bottom surface plane of the given trench. The taper angle may be calculated using the following formula: taper angle = tan⁻¹(2x(trench depth/(top trench width-bottom trench width))).

With SiC plasma etching, a low power Inductively Couple Plasma (ICP) and/or a reduction of the inert gas flow used in the gas mixture during the Reactive Ion Etching (RIE) process used for the etching of the recessed regions 104, 204, 304, 404, 504 may be applied, e.g., to generate taper angles below 90°, in the example of Fig. 3 preferably in the range between 85° and 90°. The N+ dopant 306 may be implanted through a screen oxide layer at the bottom and/or along the sidewalls of the recessed regions without the need to use tilted angle implantation steps for sidewalls implantation. In this case the sidewalls are not protected by any poly spacer during implantation and variation of the etching parameters may be used to determine the geometrical shape of the recessed regions and doping profile of the N+ doped implanted regions 306 along the sidewalls.

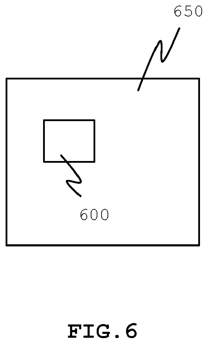

The present disclosure may advantageously be used in semiconductor devices, such as Power Devices (Schottky, PN and MPS Diodes, Mosfets, JFET), and in particular in such semiconductor devices including wide band gap semiconductor materials like SiC or Gallium nitride (GaN). Fig. 6 shows an abstract representation of an implementation of a semiconductor body 600, such as semiconductor body 100, 200, 300, 400 or 500, in a semiconductor device 650.

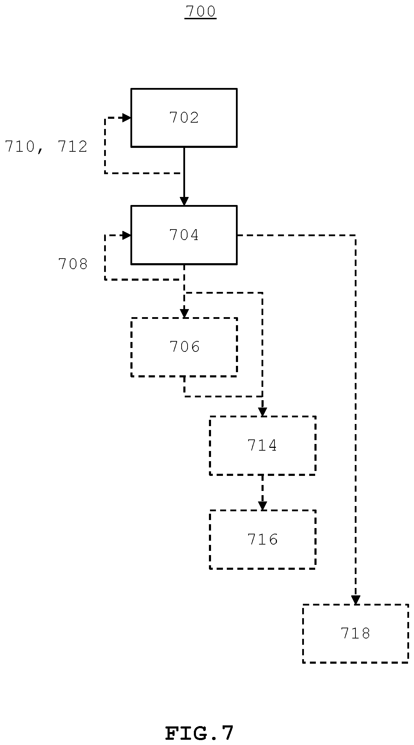

Fig. 7 shows an example embodiment of a method 700 of manufacturing a semiconductor device, such as the semiconductor device 650. Dashed boxes and dashed lines depict optional steps.

In step 702, the one or more recessed regions 104, 204, 304, 404, 504 may be formed in the P doped Junction JTE implant 102, 202, 302, 402, 502 of the semiconductor body 100, 200, 300, 400, 500, 600. The depth of the recessed regions may be smaller than the depth of the JTE implant. In an example embodiment, the depth of the recessed regions may be smaller than half of the depth of the JTE implant.

In step 704, the N+ implant 106, 206, 306, 406, 506 may be formed at a bottom of the recessed regions. In an example embodiment, the N+ implant may be formed by depositing a screen oxide layer in the recessed regions and poly spacers defined along the sidewalls by a prior photolithography and etching step.

In step 706, the N+ implant may be further formed at sidewalls of the recessed regions.

With step 708, multiple N+ implants, e.g., two N+ implants, with increasing doping at the bottom of the recessed regions may be formed. In an example embodiment, multiple N+ implants may be formed using multiple implantation steps with increasing dose and energy, producing a graded doping profile with increasing doping from a bottom of a trench to a bottom of the N+ implant.

With step 710, multiple recessed regions may be formed having a substantially constant width and a substantially constant spacing. Alternatively, with step 712, multiple recessed regions may be formed having a spacing that increases along the JTE implant from an active area up to an outer edge of a termination.

In step 714, a further recessed region may be etched outside of the JTE implant and near a die edge in a saw lane. The further recessed region may be etched during the same process 702, 710, 712 used for forming the recessed regions in the JTE.

In step 716, an N+ implant may be formed at the bottom of the further recessed region during the same process 704 used for forming the N+ implant at the bottom of the recessed regions.

In step 718, a P doped surface layer may be formed on top of a top surface or mesa of the JTE implant and in an area between the recessed regions.

It will be understood that steps may be performed in a different order, depending on the production process of the semiconductor body.

## Claims

1. A method (700) of manufacturing a semiconductor device, comprising:
forming (702) one or more recessed regions in a P doped Junction Termination Extension, JTE, implant of a semiconductor body, such that a depth of the recessed regions is smaller than a depth of the JTE implant; and
forming (704) an N+ implant at a bottom of the recessed regions.

2. The method according to claim 1, wherein the depth of the recessed regions is smaller than half of the depth of the JTE implant.

3. The method according to claim 1 or claim 2, wherein the method comprises further forming (706) the N+ implant at sidewalls of the recessed regions.

4. The method according to any one of the preceding claims, wherein the method comprises forming the N+ implant by depositing a screen oxide layer in the recessed regions and poly spacers defined along the sidewalls by a prior photolithography and etching step.

5. The method according to any one of the preceding claims, wherein the method comprises forming (708) multiple N+ implants with increasing doping at the bottom of the recessed regions.

6. The method according to claim 5, wherein the method comprises forming the multiple N+ implants using multiple implantation steps with increasing dose and energy, producing a graded doping profile with increasing doping from a bottom of a trench to a bottom of the N+ implant.

7. The method according to any one of the claims 1-6, wherein the method comprises forming (710) multiple recessed regions having a substantially constant width and a substantially constant spacing.

8. The method according to any one of the claims 1-7, wherein the method comprises forming (712) multiple recessed regions having a spacing that increases along the JTE implant from an active area up to an outer edge of a termination.

9. The method according to any one of the preceding claims, further comprising etching (714) a further recessed region outside of the JTE implant and near a die edge in a saw lane, wherein the further recessed region is etched during the same process used for forming the recessed regions in the JTE.

10. The method according to claim 9, further comprising forming (716) an N+ implant at a bottom of the further recessed region during the same process used for forming the N+ implant at the bottom of the recessed regions.

11. The method according to any one of the preceding claims, wherein the method further comprises forming (718) a P doped surface layer on top of a top surface of the JTE implant and in an area between the recessed regions.

12. A semiconductor device (650) comprising a semiconductor body (100, 200, 300, 400, 500, 600), wherein the semiconductor body comprises:
one or more recessed regions (104, 204, 304, 404, 504) in a P doped Junction Termination Extension, JTE, region (102, 202, 302, 402, 502), wherein a depth of the recessed regions is smaller than a depth of the JTE region; and
an N+ implant (106, 206, 306, 406, 506) at a bottom of the recessed regions.

13. The semiconductor device according to claim 12, wherein the N+ implant (306) further covers sidewalls of the recessed regions.

14. The semiconductor device according to any one of the claims 12-13, wherein the semiconductor body further comprises a P doped surface layer (410, 510) in an area between the recessed regions.

15. The semiconductor device according to claim 12 created using the method according to any one of the claims 1-11.
